# EUROPEAN PATENT APPLICATION

(11) **EP 2 290 725 A1**
(43) Date of publication of application: **02.03.2011**
(21) Application number: 09727045.8
(22) Date of filing: 24.03.2009
(51) Int. Cl.: H01L 51/50, H05B 33/10

(54) **ORGANIC ELECTROLUMINESCENCE ELEMENT, AND METHOD FOR PRODUCTION THEREOF**

(30) Priority: 31.03.2008 JP 2008090687
(71) Applicant: Sumitomo Chemical Company, Limited, Tokyo 104-8260 (JP)
(72) Inventor: MORISHIMA, Shinichi, Tsukuba-shi Ibaraki 305-0047 (JP)
(74) Representative: Duckworth, Timothy John
(86) International application number: PCT/JP2009/055781
(87) International publication number: WO 2009/122959

(57) **Abstract**

Disclosed is an organic electroluminescence element comprising at least an anode, a light-emitting layer, an intermediate layer and a cathode laminated sequentially in this order, wherein the intermediate layer comprises a salt of an acid of at least one metal selected from the group consisting of molybdenum, tungsten, vanadium, tantalum, titanium and metals belonging to Group IIb and at least one alkali metal selected from the group consisting of potassium, rubidium and cesium.

## Description

### TECHNICAL FIELD

The present invention relates to an organic electroluminescent device and a method for manufacturing the same.

### BACKGROUND ART

Compared with inorganic electroluminescent devices, organic electroluminescent devices have various advantages, such as that they can be driven at a lower voltage, have a higher luminance, and multicolor light emission can be easily obtained. Therefore, various investigations have been carried out in order to obtain higher performance devices. Typically, an organic electroluminescent device has a light-emitting layer including an organic material, and a pair of electrodes (an anode and a cathode) which sandwich this light-emitting layer. By applying a voltage to the pair of electrodes, holes are injected from the anode and electrons are injected from the cathode. These holes and electrons combine in the light-emitting layer, whereby light is emitted.

In such an organic EL device, to lower the drive voltage and to lengthen the device life, intermediate layers different from the light-emitting layer are provided between the electrodes and the light-emitting layer. Examples of such intermediate layers include an electron injection layer, a hole injection layer, a hole transport layer, and an electron transport layer.

For example, NON-PATENT DOCUMENT 1 proposes inserting an electron injection layer formed from a metal having a low work function, such as an alkali metal or an alkali earth metal, between the cathode and the light-emitting layer. However, by themselves, metals having a low work function are extremely reactive and are unstable in air. Therefore, there is the problem that the device has low environmental durability. NON-PATENT DOCUMENT 2 proposes using a fluoride or an oxide of a metal having a low work function for the electron injection layer. Further, PATENT DOCUMENT 1 proposes using an alkali metal oxide for the electron injection layer. In addition, for example, PATENT DOCUMENT 2 describes providing an electron injection layer formed from an inorganic oxide, such as molybdenum oxide, between the light-emitting layer and the electron injection electrode.

PATENT DOCUMENT 1: JP 9-17574 A
PATENT DOCUMENT 2: JP 2002-367784 A
NON-PATENT DOCUMENT 1: Journal of Applied Physics, 88 (2000) p. 3618
NON-PATENT DOCUMENT 2: Applied Physics Letters, 70 (1997) p. 152

### DISCLOSURE OF THE INVENTION

### PROBLEMS TO BE SOLVED BY THE INVENTION

Even if an electron injection layer formed from a fluoride or an oxide of a metal having a low work function, or an inorganic oxide such as molybdenum oxide, or an alkali metal oxide, is provided, luminance and output efficiency cannot always be said to both be sufficient. Further, an electron injection layer formed from an inorganic oxide such as molybdenum oxide is formed using a method such as codeposition, which makes it difficult to control the composition. Thus, there is the problem that the device cannot be easily manufactured.

Accordingly, it is an object of the present invention to provide an organic EL device having good luminance and output efficiency, and manufacturing method capable of easily manufacturing this organic EL device.

### MEANS FOR SOLVING THE PROBLEMS

Based on extensive investigations considering such circumstances, the present inventors have discovered that device emission properties and life characteristics can be improved by providing an intermediate layer which includes a salt having a specific combination between a cathode and a light-emitting layer. This finding has led the inventors to complete the present invention.
The present invention is an organic electroluminescent device formed by laminating at least an anode, a light-emitting layer, an intermediate layer, and a cathode in this order, characterized in that the intermediate layer includes a salt of an acid of one or more metals selected from the group consisting of molybdenum, tungsten, vanadium, tantalum, titanium, and Group IIb metals with one or more alkali metals selected from the group consisting of potassium, rubidium, and cesium.
Further, the present invention is an organic electroluminescent device, wherein the salt is one or more member selected from the group consisting of potassium tungstate, potassium molybdate, cesium molybdate, and cesium vanadate.
Further, the present invention is an organic electroluminescent device, wherein the content of the salt in the intermediate layer is 5 mass% to 100 mass%.
Further, the present invention is an organic electroluminescent device, wherein the intermediate layer is arranged in contact with the light-emitting layer.
Further, the present invention is an organic electroluminescent device, wherein the intermediate layer is arranged in contact with the cathode.
Further, the present invention is an organic electroluminescent device, wherein light is extracted through the cathode side.
Further, the present invention is an organic electroluminescent device, wherein the light-emitting layer includes a polymer compound.
Further, the present invention is a method for manufacturing the above-described organic electroluminescent device, characterized in that the method includes the steps of:
forming the anode;
forming the light-emitting layer by an applying method;
forming the intermediate layer by vacuum vapor deposition, sputtering, or ion plating using as a starting material a salt of an acid of one or more metals selected from the group consisting of molybdenum, tungsten, vanadium, tantalum, titanium, and Group IIb metals with one or more alkali metals selected from the group consisting of potassium, rubidium, and cesium; and
forming the cathode.

### ADVANTAGES OF THE INVENTION

According to the present invention, an organic EL device having good luminance and output efficiency can be realized by providing an intermediate layer including a salt of an acid of one or more metals selected from the group consisting of molybdenum, tungsten, vanadium, tantalum, titanium, and Group IIb metals with one or more alkali metals selected from the group consisting of potassium, rubidium, and cesium, between a cathode and a light-emitting layer.

### BRIEF DESCRIPTION OF THE DRAWING

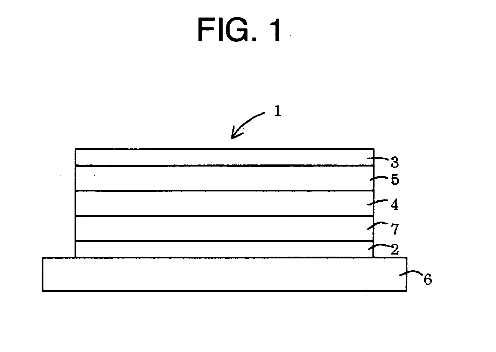

Fig. 1 is a front view illustrating an organic EL device 1 according to an embodiment of the present invention.

### DESCRIPTION OF REFERENCE NUMERALS

1 Organic EL device
2 Anode
3 Cathode
4 Light-emitting layer
5 Electron injection layer
6 Substrate
7 Hole injection layer

### BEST MODE FOR CARRYING OUT THE INVENTION

Fig. 1 is a front view illustrating an organic electroluminescent device (hereinafter, sometimes referred to as organic EL device) 1 according to an embodiment of the present invention. The organic EL device 1 according to the present embodiment is used, for example, for a power source in a display device such as a full color display device, an area color display device, or a liquid crystal display device, and a lighting device.

The organic EL device 1 according to the present embodiment is configured by laminating at least an anode 2, a light-emitting layer 4, an intermediate layer (in the present embodiment, an electron injection layer 5), and a cathode 3, in this order. This intermediate layer (in the present embodiment, an electron injection layer 5) includes a salt of an acid of one or more metals selected from the goup consisting of molybdenum, tungsten, vanadium, tantalum, titanium, and Group IIb metals with one or more alkali metals selected from the group consisting of potassium, rubidium, and cesium. The organic EL device is manufactured by a method for manufacturing an organic EL device according to the present embodiment, which includes the steps of forming the anode; forming the light-emitting layer by an applying method; forming the intermediate layer by vacuum vapor deposition, sputtering, or ion plating using the salt; and forming the cathode. The organic EL device 1 according to the present embodiment may be formed so that at least the light-emitting layer and the intermediate layer including the salt are provided between the cathode and the anode. The organic EL device 1 may also include one or a plurality of layers in addition to the light-emitting layer and the intermediate layer. The organic EL device 1 according to the present embodiment further includes a hole injection layer 7 provided between the anode 2 and the light-emitting layer 4, so that it is configured by laminating the anode 2, the hole injection layer 7, the light-emitting layer 4, the electron injection layer 5, and the cathode 3 on a substrate 6 in this order.

The organic EL device 1 according to the present embodiment is a so-called "bottom emission" type device, in which light from the light-emitting layer 4 is extracted from the substrate 6 side. Therefore, the substrate 6 preferably has a high transmittance of light in the visible region. Further, it is also preferred to use a substrate 6 which does not change during the step of forming the organic EL device 1. A rigid substrate or a flexible substrate may be used. Preferred examples which may be used include glass, plastic, a polymer film, a silicon substrate, a metal plate, and a layered substrate of these. In addition, a substrate formed by subjecting plastic, a polymeric film and the like to a low-moisture-permeability treatment may also be used. A commercially-available product may be used for the substrate 6.
Alternatively, a substrate manufactured by a known method may be used for the substrate 6. Further, a so-called top-emission type organic EL device, in which the light is extracted from the opposite side to the substrate with respect to the light-emitting layer, may also be produced. In such a device, the substrate may be impermeable to light. In addition, the substrate 6 may be formed with a transistor circuit or wires on the substrate for driving the organic EL device. An insulating layer may be laminated on this transistor. Further, the substrate may also be formed with a structure (i.e., a partition) thereon for dividing the film-forming region of the light-emitting layer 4.

It is preferred to use a thin film having a low electrical conductivity for the anode 2. At least one of the anode 2 and the cathode 3 is transparent. For example, for a bottom emission type organic EL device, the anode 2 arranged on the substrate 6 side is transparent, so that it is preferred to use a material having a high transmittance of light in the visible region.
As the anode 2 material, a conductive metal oxide film, metal thin film and the like may be used. Specifically, a thin film formed from indium oxide, zinc oxide, tin oxide, indium tin oxide (ITO), and indium zinc oxide (IZO), gold, platinum, silver, copper, aluminum, or an alloy containing al least one of those metals is used for the anode 2. Among these, based on transmittance and ease of patterning, it is preferred to use a thin film formed from ITO, IZO, and tin oxide as the anode 2. If extracting the light through the cathode 3 side, it is preferred to form the anode 2 from a material which reflects the light from the light-emitting layer 4 to the cathode 3 side. Such material preferably is a metal, metal oxide, or metal sulfide having a work function of 3.0 eV or more. For example, a metal thin film having a thickness which is sufficient to reflect light is used.

Examples of methods for producing the anode 2 include vacuum vapor deposition, sputtering, ion plating, and plating. Further, as the anode 2, a transparent conductive film of an organic material, such as polyaniline or derivatives thereof and polythiophene or derivatives thereof may be used. In addition, a mixture including two or more of the material used for the above-described organic transparent conductive film, a metal oxide, a metal sulfate, a metal, a carbon material such as carbon nanotubes and the like may also be used. The thickness of the anode can be appropriately selected in consideration of light transmittance and electrical conductivity. The thickness is, for example, 1 nm to 10 µm, preferably 2 nm to 1 µm, and more preferably 3 nm to 500 nm.

The hole injection layer 7 is a layer having a function for improving the hole injection efficiency from the anode 2. The hole injection material constituting the hole injection layer 7 is not especially limited, and known materials may be appropriately used. Examples thereof include a phenylamine compound, a starburst-type amine compound, a phthalocyanine compound, hydrazone derivatives, carbazole derivatives, triazole derivatives, imidazole derivatives, oxadiazole derivatives having an amino group, oxides such as vanadium oxide, molybdenum oxide, ruthenium oxide, and aluminum oxide, amorphous carbon, polyaniline, and polythiophene derivatives.

The hole injection layer 7 is formed, for example, by an applying method using a coating solution including the above-described hole injection material. As the coating solution solvent, a solvent which dissolves the hole injection material may be used. Examples of the coating solution solvent include chlorinated solvents such as chloroform, water, methylene chloride and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate and ethyl cellosolve acetate.

Examples of the coating method include spin coating, casting, micro gravure coating, gravure coating, bar coating, roll coating, wire bar coating, dip coating, spray coating, screen printing, flexographic printing, offset printing, inkjet printing and the like. The hole injection layer 7 can be formed using one of these coating methods, by coating the above-described coating solution on the substrate 6 on which the anode 2 is formed.

The hole injection layer 7 can also be formed using vacuum vapor deposition and the like. In addition, if the hole injection layer 7 is formed from a metal oxide, methods such as sputtering and ion plating may also be used.

The optimum thickness of the hole injection layer 7 depends on the used material, and is selected so that the drive voltage and the light emission efficiency are appropriate values. Further, the hole injection layer 7 needs to be thick enough so that pin holes do not form. However, the thickness is preferably not too thick, otherwise the drive voltage of the device increases. Therefore, the hole injection layer 7 has a thickness of, for example, from 1 nm to 1 µm, preferably 2 nm to 500 µm, and more preferably 5 nm to 200 nm.

The light-emitting layer 4 is formed from an organic material which emits fluorescence and/or phosphorescence. Further, the light-emitting layer 4 may also include a dopant. The dopant is added for the purpose of, for example, improving the light emission efficiency, and changing the emission wavelength. The light-emitting material used for the light-emitting layer 4 may be a low-molecular weight compound or a polymeric compound. However, it is preferred that the light-emitting layer 4 includes a polymeric compound. Examples of the light-emitting material include the following.

Examples of pigment light-emitting materials include a cyclopentamine derivative, a tetraphenyl butadiene derivative compound, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a perinone derivative, a perylene derivative, an oligothiophene derivative, an oxadiazole dimer, a pyrazoline dimer, a quinacridone derivative, and a coumarin derivative.

Examples of the metal complex light-emitting materials include a metal complex having, for a central metal, a rare earth metal such as Tb, Eu, and Dy, or Al, Zn, Be and the like, and for a ligand, an oxadiazole, a thiadiazole, a phenylpyridine, a phenylbenzimidazole, a quinoline structure and the like. Further examples include metal complexes which emit light from a triplet excited state, such as indium complexes and platinum complexes, and metal complexes such as an aluminum quinolinol complex, a benzoquinolinol beryllium complex, a benzoxazolyl zinc complex, a benzothiazole zinc complex, an azomethyl zinc complex, a porphyrin zinc complex, and europium complexes.

Examples of polymeric light-emitting materials include poly(p-phenylenevinylene) derivatives, polythiophene derivatives, poly(p-phenylene) derivatives, polysilane derivatives, polyacetylene derivatives, polyfluorene derivatives, polyvinylcarbazole derivatives, and polymers prepared by polymerizing the above-described pigment light-emitting material or metal complex light-emitting material.

Of these light-emitting materials, examples of blue emitting materials include distyrylarylene derivatives, oxadiazole derivatives and polymers thereof, polyvinylcarbazole derivatives, poly(p-phenylene) derivatives, and polyfluorene derivatives. Of these, polyvinylcarbazole derivatives, poly(p-phenylene) derivatives, polyfluorene derivatives, and the like, which are polymer materials, are preferred.

Examples of green emitting materials include quinacridone derivatives, coumarin derivatives, and polymers thereof, poly(p-phenylenevinylene) derivatives and polyfluorene derivatives. Of these, poly(p-phenylenevinylene) derivatives, polyfluorene derivatives, and the like, which are polymer materials, are preferred.

Examples of red emitting materials include coumarin derivatives, thiophene ring compounds, and polymers thereof, poly(p-phenylenevinylene) derivatives, polythiophene derivatives, and polyfluorene derivatives. Of these, poly(p-phenylenevinylene) derivatives, polythiophene derivatives, polyfluorene derivatives, and the like, which are polymer materials, are preferred.

Examples of dopant materials include perylene derivatives, coumarin derivatives, rubrene derivatives, quinacridone derivatives, squalium derivatives, porphyrin derivatives, styryl dyes, tetracene derivatives, pyrazolone derivatives, decacyclene, and phenoxazone. The thickness of such a light-emitting layer 4 is usually about 2 nm to 2,000 nm.

Examples of methods for forming the light-emitting layer 4 include an applying method for coating a solution including the light-emitting material onto the surface of the substrate, vacuum vapor deposition, and a transfer method. Among these, based on ease of manufacturing process, it is preferred to form the light-emitting layer by an applying method. Examples of solvents for the coating solution including the light-emitting material which can be used include the solvents described above as the coating solution solvent for forming the hole injection layer 7.

Examples of methods for coating a solution including the light-emitting material include coating methods such as spin coating, casting, micro gravure coating, gravure coating, bar coating, roll coating, wire bar coating, dip coating, slit coating, capillary coating, spray coating, and nozzle coating, as well as other coating methods such as gravure printing, screen printing, flexographic printing, offset printing, reverse printing, and inkjet printing. From the standpoint that pattern formation and separation into multiple colors are easy, gravure printing, screen printing, flexographic printing, offset printing, reverse printing, inkjet printing and the like are preferred. Further, for a sublimable low molecular weight compound, vacuum vapor deposition can be used. Moreover, the light-emitting layer 4 can also be formed on only a desired region by a transfer method or a thermal transfer method performed with a laser or by abrasion.

The electron injection layer 5 is provided between the cathode 3 and the light-emitting layer 4 mainly to improve the injection efficiency of electrons from the cathode 3. The electron injection layer 5 includes a salt of an acid of one or more metals selected from the group consisting of molybdenum, tungsten, vanadium, tantalum, titanium, and Group IIb metals with one or more alkali metals selected from the group consisting of potassium, rubidium, and cesium. By configuring with the electron injection layer 5 having such a salt, the device emission properties and the life characteristics can be improved.

Among the acids of Group IIb metals, a zinc acid is preferred. Further, among the acids of one or more metals selected from the group consisting of molybdenum, tungsten, vanadium, tantalum, titanium, and Group IIb metals, from the perspective of ease of material availability, a molybdenum acid, a tungsten acid, a tantalum acid, and a zinc acid are preferred. Specific examples of the salt of an acid of one or more metals selected from the group consisting of molybdenum, tungsten, vanadium, tantalum, titanium, and Group IIb metals with one or more alkali metals selected from the group consisting of potassium, rubidium, and cesium, include one or more selected from the group consisting of potassium molybdate, potassium tungstate, potassium vanadate, potassium tantalate, potassium titanate, potassium zincate, rubidium molybdate, rubidium tungstate, rubidium vanadate, rubidium tantalate, rubidium titanate, rubidium zincate, cesium molybdate, cesium tungstate, cesium vanadate, cesium tantalate, cesium titanate, and cesium zincate. Preferred are one or more selected from the group consisting of potassium tungstate, potassium molybdate, cesium molybdate, and cesium vanadate. From the perspective of improving the light emission efficiency of the organic EL device, especially preferred are potassium molybdate and potassium tungstate. From the perspective of lowering the drive voltage of the organic EL device, cesium molybdate is preferred. Further, the electron injection layer may also include cesium niobate and rubidium niobate.

The content of the above-described salt in the electron injection layer may be a level at which an effect in improving the device properties and the life characteristics is exhibited. Preferably, the salt content is 5 mass% to 100 mass%, more preferably 20 mass% to 100 mass%, and even more preferably 40 mass% to 100 mass%. If at least one layer of the intermediate layer including the above-described salt is arranged between the cathode and the light-emitting layer, the electron injection layer may be configured as a layer which does not include the above-described salt. For example, the electron injection layer may be formed from a material which does not cause much damage to the light-emitting layer, and which hinders the electron injection properties as little as possible. Further, the electron injection layer may be formed from the materials described below as example of the electron transport layer material. Although there are, as described above, a plurality of kinds of the above-described salt, the electron injection layer may include two kinds or more of the salt. In addition, the electron injection layer may be formed by a member, for the above-described salt, which is doped with an element different from the element constituting the salt. Examples of elements which can be doped in the above-described salt include aluminum, indium, gallium, gold, silver, tin, copper, nickel, chromium, silicon, alkaline earth metals, and carbon. The salt of an acid of one or more metals selected from the group consisting of molybdenum, tungsten, vanadium, tantalum, titanium, and Group IIb metals with one or more alkali metals selected from the group consisting of potassium, rubidium, and cesium, may depart from the stoichiometric ratios.

Generally, alkali metals are known to readily diffuse in the light-emitting layer, and thus become a factor in quenching which hinders light emission, which can cause light emission efficiency to dramatically deteriorate. However, since the potassium, rubidium, and cesium in the electron injection layer are stably present in the form of a salt, a longer device life can be achieved.

The intermediate layer (in the present embodiment, the electron injection layer) is preferably arranged in contact with the light-emitting layer. As described above, the potassium, rubidium, and cesium in the electron injection layer are stably present in the form of a salt. Therefore, even if the electron injection layer is directly laminated on the light-emitting layer, it can also be considered that there is no pronounced release of the potassium, rubidium, or cesium, and that there is little risk of the potassium, rubidium, and cesium diffusing in the light-emitting layer and becoming a factor in quenching. Thus, since electrons can be directly injected from the electron injection layer to the light-emitting layer, the below-described electron transport layer can be omitted. This allows an organic EL device having a simple structure to be realized, and can even allow the production steps of the organic EL device to be simplified.

Further, it is preferred to arrange the intermediate layer (in the present embodiment, the electron injection layer) in contact with the cathode. For example, if a layer including impurities which hinder electron injection or a layer having a low electrical conductivity is provided between the electron injection layer and the cathode, the injection efficiency of electrons into the light-emitting layer can deteriorate, and the drive voltage may even increase. However, by providing the electron injection layer in contact with the cathode, the injection efficiency of electrons into the light-emitting layer is increased, and the drive voltage can be decreased.

The intermediate layer (in the present embodiment, the electron injection layer) can be formed by a method such as vacuum vapor deposition, sputtering, ion plating, molecular beam vapor deposition, and ion beam vapor deposition, and is preferably formed by vacuum vapor deposition, sputtering, or ion plating using the above-described salt for the starting material. Examples of vacuum vapor deposition methods include plasma assist vacuum vapor deposition, in which a plasma is introduced into the film-forming chamber to improve reactivity and film-forming properties. Examples of the vapor source in the vacuum vapor deposition include resistance heating, electron beam heating, high-frequency induction heating, laser beam heating and the like. Among these, resistance heating, electron beam heating, and high-frequency induction heating are preferred for their convenience. Examples of sputtering methods include DC sputtering, RF sputtering, ECR sputtering, conventional sputtering, magnetron sputtering, ion beam sputtering, facing target sputtering and the like. Among these, to prevent damage to the layers formed before the electron injection layer, it is preferred to use magnetron sputtering, ion beam sputtering, or facing target sputtering. During film forming, the vapor deposition may also be carried out while introducing oxygen or a gas containing the element oxygen into the atmosphere.

The optimum thickness of the electron injection layer 5 depends on the used material, and is selected so that the drive voltage and the light emission efficiency are appropriate values. Further, the electron injection layer 5 needs to be thick enough so that pin holes do not form. However, the thickness is preferably not too thick, otherwise the drive voltage of the device increases. Therefore, the electron injection layer 5 has a thickness of, usually, from 0.5 nm to 1 µm, preferably 1 nm to 200 nm and more preferably 2 nm to 150 nm.

Compared with a method for forming an electron injection layer by co-deposition while precisely controlling the composition ratio of an alkali metal, which is very unstable in air, and an oxide, using a salt that is relatively stable in air for the material obviates the need to control the composition ratio, and allows an electron injection layer to be formed at a relatively low temperature with little energy. Consequently, the manufacturing steps are simpler, and an organic EL device can be produced at a lower cost.

It is preferred that the cathode 3 material has a small work function, allows easy electron injection into the light-emitting layer 4, and has a high electrical conductivity. Further, in the case of extracting light from the anode 2 side, a material having a high visible light reflectance is preferred so that the light from the light-emitting layer 4 is reflected to the anode 2 side. Examples of materials which can be used for the cathode 3 include alkali metals, alkali earth metals, transition metals, and Group IIIb metals. Specific examples of the material used for the cathode 3 include lithium, sodium, potassium, rubidium, cesium, beryllium, magnesium, calcium, strontium, barium, aluminum, scandium, vanadium, zinc, yttrium, indium, cerium, samarium, europium, terbium, ytterbium, gold, silver, platinum, copper, manganese, titanium, cobalt, nickel, tungsten, and tin, an alloy containing at least one or more of these metals, or graphite or a graphite intercalation compound. Examples of alloys include magnesium-silver alloy, magnesium-indium alloy, magnesium-aluminum alloy, indium-silver alloy, lithium-aluminum alloy, lithium-magnesium alloy, lithium-indium alloy, and calcium-aluminum alloy.

Further, in the case of configuring the device to extract light through the cathode 3 side, a transparent conductive electrode may be used as the cathode 3. For example, a thin film formed from a conductive metal oxide, such as indium oxide, zinc oxide, tin oxide, ITO, and IZO, may be used. Alternatively, a thin film formed from a conductive organic material, such as polyaniline or derivatives thereof and polythiophene or derivatives thereof, may be used. In addition, the cathode may be configured by laminating two or more layers.

The organic EL device 1 according to the present embodiment is formed from the anode 2, the hole injection layer 7, the light-emitting layer 4, the electron injection layer 5, and the cathode 3, on the substrate 6 in this order. As a modified example, the organic EL device 1 may be formed by laminating, on the substrate, the cathode, the electron injection layer, the light-emitting layer, the hole injection layer, and the anode, in this order.

As described above, the organic EL device according to the present embodiment is configured so that an intermediate layer, which includes a salt of an acid of one or more metals selected from the group consisting of molybdenum, tungsten, vanadium, tantalum, titanium, and Group IIb metals with one or more alkali metals selected from the group consisting of potassium, rubidium, and cesium, is provided between the light-emitting layer and the cathode. This intermediate layer is not limited to an electron injection layer. Further, the layer structure between the anode 2 and the cathode 3 is not limited to the layer structure of the organic EL device 1 according to the present embodiment. Although it is typical for one light-emitting layer to be provided, two or more light-emitting layers may be provided. In such a case, the two or more light-emitting layers can be laminated in direct contact with each other, or can be provided with a layer other than a light-emitting layer provided thereinbetween.

An example of the layer structure provided between the anode 2 and the cathode 3 will now be described. In the following, overlapping descriptions concerning the anode, the cathode, the light-emitting layer, the hole injection layer, and the electron injection layer are in some cases omitted.

Examples of layers that can be provided between the cathode and the light-emitting layer include an electron injection layer, an electron transport layer, and a hole blocking layer. When both an electron injection layer and an electron transport layer are provided between the cathode and the light-emitting layer, the layer positioned on the side closer to the cathode is called an electron injection layer, and the layer positioned on the side closer to the light-emitting layer is called an electron transport layer.

The electron injection layer is a layer that has a function for improving the electron injection efficiency from the cathode. The electron transport layer is a layer that has a function for improving electron injection from the cathode or the electron injection layer, or from an electron transport layer which is closer to the cathode. A hole blocking layer is a layer that has a function for blocking hole transportation. The electron injection layer or the electron transport layer can simultaneously serve as a hole blocking layer.

Examples of layers that are provided between the anode and the light-emitting layer include the above-described hole injection layer, a hole transport layer, and an electron blocking layer. When both a hole injection layer and a hole transport layer are provided between the anode and the light-emitting layer, the layer positioned on the side closer to the anode is called a hole injection layer, and the layer positioned on the side closer to the light-emitting layer is called a hole transport layer.

The hole injection layer is a layer that has a function for improving the hole injection efficiency from the anode. The hole transport layer is a layer that has a function for improving hole injection from the anode or the hole injection layer, or from a hole transport layer which is closer to the anode. An electron blocking layer is a layer that has a function for blocking electron transportation. The hole injection layer or the hole transport layer can simultaneously serve as an electron blocking layer.

The electron injection layer and the hole injection layer may be collectively referred to as charge injection layers, and the electron transport layer and the hole transport layer may be collectively referred to as charge transport layers. Further, the electron blocking layer and the hole blocking layer may be collectively referred to as charge blocking layers.

Specific examples of the layer structures which the organic EL device can have are illustrated below.
a) Anode/hole injection layer/hole transport layer/light-emitting layer/electron transport layer/electron injection layer/cathode
b) Anode/hole injection layer/hole transport layer/light-emitting layer/electron transport layer/cathode
c) Anode/hole injection layer/hole transport layer/light-emitting layer/electron injection layer/cathode
d) Anode/hole injection layer/light-emitting layer/electron transport layer/electron injection layer/cathode
e) Anode/hole injection layer/light-emitting layer/electron transport layer/cathode
f) Anode/hole injection layer/light-emitting layer/electron injection layer/cathode
g) Anode/hole transport layer/light-emitting layer/electron transport layer/electron injection layer/cathode
h) Anode/hole transport layer/light-emitting layer/electron transport layer/cathode
i) Anode/hole transport layer/light-emitting layer/electron injection layer/cathode
j) Anode/light-emitting layer/electron transport layer/electron injection layer/cathode
k) Anode/light-emitting layer/electron transport layer/cathode
l) Anode/light-emitting layer/electron injection layer/cathode (here, the symbol "/" represents the fact that the two layers on either side of the "/" are laminated adjacent to each other. Hereinafter the same.)
In each of the above-described examples of layer structures, an electron blocking layer can be inserted between the light-emitting layer and the anode. Further, a hole blocking layer can also be inserted between the light-emitting layer and the cathode.

The organic EL device may also have two or more light-emitting layers. Examples of the device structure of an organic EL device having two light-emitting layers include the following.
m) Anode/hole injection layer/hole transport layer/light-emitting layer/electron transport layer/electron injection layer/electrode/hole injection layer/hole transport layer/light-emitting layer/electron transport layer/electron transport layer/cathode
   Further, examples of the device structure of an organic EL device having three or more light-emitting layers include, wherein (electrode/hole injection layer/hole transport layer/light-emitting layer/electron transport layer/electron injection layer) is one repeating unit, the following structures which include two or more of the above repeating unit.
n) Anode/charge injection layer/hole transport layer/light-emitting layer/electron transport layer/charge injection layer/(repeating unit)/.../cathode
In the above-described layer structures m and n, layers other than the anode, the cathode, and the light-emitting layer may optionally be omitted.

For a bottom emission type organic EL device, in which the light is extracted from the substrate 6, the layers arranged on the substrate 6 side with respect to the light-emitting layer are all transparent. For a so-called top emission type organic EL device, in which the light is extracted through the cathode 3 side opposite to the substrate 6 side, the layers arranged on the cathode 3 side with respect to the light-emitting layer are all transparent.

To further improve adhesion with the electrodes and to improve the charge injection efficiency from the electrodes, the organic EL device may be provided with an insulating layer having a thickness of 2 nm or less adjacent to the electrodes. Further, to improve adhesion at the interfaces and to prevent mixing of the respective layers, a thin buffer layer may be inserted on the interface between adjacent layers.

Specific structures of the respective layers will now be described.

### <Hole transport layer>

The hole transport material constituting the hole transport layer is not especially limited. Examples thereof include aromatic amine derivatives such as N,N'-diphenyl-N,N'-di(3-methylphenyl)4,4'-diaminobiphenyl (TPD) and NPB (4,4'-bis[N-(1-naphthyl)-N-phenylamino]biphenyl), polyvinylcarbazole or derivatives thereof, polysilane or derivatives thereof, polysiloxane derivatives having an aromatic amine in a side chain or in the main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylenevinylene) or derivatives thereof, and poly(2,5-thienylenevinylene) or derivatives thereof.

Among these hole transport materials, as the hole transport material, it is preferred to use a polymeric hole transport material, such as polyvinylcarbazole or derivatives thereof, polysilane or derivatives thereof, polysiloxane derivatives having an aromatic amine compound group in a side chain or in the main chain, polyaniline or derivatives thereof, polythiophene or derivatives thereof, polyarylamine or derivatives thereof, poly(p-phenylenevinylene) or derivatives thereof or poly(2,5-thienylenevinylene) or derivatives thereof. Further, it is more preferred to use polyvinylcarbazole or derivatives thereof, polysilane or derivatives thereof, and polysiloxane derivatives having an aromatic amine in a side chain or in the main chain. For a low molecular weight hole transport material, it is preferred to use such a material by dispersing it in a polymeric binder.

Examples of the method for forming the hole transport layer include, for a low molecular weight hole transport material, forming the layer from a mixed solution with a polymeric binder, and for a polymeric hole transport material, forming the layer from a solution.

As the solvent used for forming from a solution, a solvent in which the hole transport material is dissolved may be used. Examples thereof include chlorinated solvents such as chloroform, methylene chloride and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate and ethyl cellosolve acetate.

Examples of the method for forming from a solution include the same coating methods as described for the method for forming the hole injection layer.

As the mixed polymeric binder, it is preferred to use a binder that does not excessively inhibit charge transportation, and also preferred to use a binder that has a weak absorbance of visible light. Examples of such a polymeric binder include polycarbonate, polyacrylate, polymethyl acrylate, polymethyl methacrylate, polystyrene, polyvinyl chloride and polysiloxane.

The optimum thickness of the hole transport layer depends on the used material, and is selected so that the drive voltage and the light emission efficiency are appropriate values. Further, the hole transport layer needs to be thick enough so that pin holes do not form. However, the thickness is preferably not too thick, otherwise the drive voltage of the device increases. Therefore, the hole transport layer has a thickness of, for example, from 1 nm to 1 µm, preferably 2 nm to 500 nm, and more preferably 5 nm to 200 nm.

### <Electron transport layer>

Examples of the electron transport material constituting the electron transport layer include a salt of an acid of one or more metals selected from the group consisting of molybdenum, tungsten, vanadium, tantalum, titanium, and Group IIb metals with one or more alkali metals selected from the group consisting of potassium, rubidium, and cesium, oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, or metal complexes of 8-hydroxyquinoline or derivatives thereof, polyquinoline or derivatives thereof, polyquinoxaline or derivatives thereof and polyfluorene or derivatives thereof Examples of the salt of an acid of one or more metals selected from the group consisting of molybdenum, tungsten, vanadium, tantalum, titanium, and Group IIb metals with one or more alkali metals selected from the group consisting of potassium, rubidium, and cesium include the salts described above as examples for the electron injection layer.

Among these, as the electron transport material, preferable are oxadiazole derivatives, benzoquinone or derivatives thereof, anthraquinone or derivatives thereof, or metal complexes of 8-hydroxyquinoline or derivatives thereof, polyquinoline or derivatives thereof, polyquinoxaline or derivatives thereof and polyfluorene or derivatives thereof, and more preferable are 2-(4-biphenylyl)-5-(4-t-butylphenyl)-1,3,4-oxadiazole, benzoquinone, anthraquinone, tris(8-quinolinol)aluminum and polyquinoline.

Examples of methods for forming the electron transport layer include, for a low molecular weight electron transport material, vacuum vapor deposition from a powder, or forming the layer from a solution or a molten state. For polymeric electron transport materials, examples include a method in which the layer is formed from a solution or a molten state. When performing film-formation from a solution or a molten state, the polymeric binder may be used simultaneously. Examples of methods for forming the electron transport layer from a solution include the same methods as described above for forming the hole transport layer from a solution. In addition, the electron transport layer may also be formed by vacuum vapor deposition, sputtering, or ion plating using as a starting material a salt of an acid of one or more metals selected from the group consisting of molybdenum, tungsten, vanadium, tantalum, titanium, and Group IIb metals with one or more alkali metals selected from the group consisting of potassium, rubidium, and cesium.

The optimum thickness of the electron transport layer depends on the used material, and may be selected so that the drive voltage and the light emission efficiency are appropriate values. Further, the electron transport layer needs to be thick enough so that pin holes do not form. However, the thickness is preferably not too thick, otherwise the drive voltage of the device increases. Therefore, the electron transport layer has a thickness of, for example, from 1 nm to 1 µm, preferably 2 nm to 500 nm, and more preferably 5 nm to 200 nm.

### EXAMPLES

### (Example 1)

An organic EL device was produced having a device structure of glass substrate/anode formed from an ITO thin film/hole injection layer/electron blocking layer/light-emitting layer/electron injection layer/cathode/sealing glass. This organic EL device is described in more detail below.

### <Preparation example>

A polymer compound 1 to serve as the material for the above-described electron blocking layer was produced. First, a separable flask including a stirring blade, a baffle, a nitrogen introducing tube whose length was adjustable, a cooling tube, and a thermometer, was charged with 158.29 parts by weight of 2,7-bis(1,3,2-dioxaborolane-2-yl)-9,9-dioctylfluorene, 136.11 parts by weight of bis(4-bromophenyl)-4-(1-methylpropyl)-benzenamine, 27 parts by weight oftricaprylmethylammonium chloride (Aliquat 336, manufactured by Henkel) and 1,800 parts by weight of toluene. While introducing nitrogen from the nitrogen introducing tube, the temperature was increased to 90°C under stirring. After adding 0.066 parts by weight of palladium (II) acetate and 0.45 parts by weight of tri(o-toluyl)phosphine, 573 parts by weight of an aqueous solution of 17.5% sodium carbonate was dropped over one hour. After completion of the dropping, the nitrogen introducing tube was pulled up from the solution surface, and the solution was kept warm under reflux for 7 hours. Then, 3.6 parts by weight of phenylboric acid was added. The temperature was kept warm under reflux for 14 hours, and then cooled to room temperature. The aqueous layer was removed from the reaction solution. Subsequently, the oil layer of the reaction solution was diluted with toluene, and washed with an aqueous solution of 3% acetic acid and deionized water. The separated oil layer was charged with 13 parts by weight of sodium N,N-diethyldithiocarbamate trihydrate, and the resultant mixture was stirred for 4 hours. Then, the mixture was passed through a mixed column of active alumina and silica gel. Toluene was passed through the column to wash the column. The filtrate and the washing solution were mixed, and dropped into methanol to precipitate a polymer. The resultant polymer precipitate was filtered off, and then the precipitate was washed with methanol. Subsequently, the polymer was dried by a vacuum dryer, thus obtaining 192 parts by weight of the polymer. The obtained polymer will be referred to as polymer compound 1. The polystyrene equivalent weight average molecular weight of the polymer compound 1 was 3.7x 10⁵ and the number average molecular weight was 8.9x10⁴.

### (GPC analysis method)

The polystyrene equivalent weight average molecular weight and the number average molecular weight were determined by gel permeation chromatography (GPC). Standard polystyrene manufactured by Polymer Laboratories was used to prepare a GPC calibration curve. The polymer to be measured was dissolved in tetrahydrofuran to a concentration of about 0.02 wt.%, and 10 µL thereof was injected into a GPC apparatus. LC-10ADvp manufactured by Shimadzu Corporation was used as the GPC apparatus. Two PLgel 10 µm MIXED-B columns (300 x 7.5 mm) manufactured by Polymer Laboratories connected in series were used as the column. Tetrahydrofuran was flowed at a flow rate of 1.0 mL/min at 25°C as a mobile phase. A UV detector was used as a detector. Absorbance at 228 nm was measured.

### <Organic EL device production>

A glass substrate was used for the substrate. An ITO thin film formed on the surface of this substrate by sputtering and then patterned into a predetermined shape was used for the anode. The thickness of the ITO thin film was about 150 nm.

A suspension of poly(3,4)ethylenedioxythiophene/polystyrene sulfonic acid (trade name: Bytron P/TP AI 4083, manufactured by H.C. Starck VTech) was filtered with a filter having a 0.5 µm diameter. The filtrate was coated on the glass substrate formed with the ITO thin film thereon by spin coating to form a film having a thickness of 60 nm. Next, the film formed on the extraction sections of the electrodes and the sealing area was wiped off Then, drying was carried out at about 200°C for 10 minutes under an air atmosphere using a hot plate to form the hole injection layer.

Next, a solution containing the above-described polymer compound 1 was coated on the substrate formed with the hole injection layer thereon by spin coating to form a film having a thickness of about 20 nm. Next, the film formed on the extraction sections of the electrodes and the sealing area was wiped off. Then, baking treatment was carried out at about 200°C for 20 minutes under a nitrogen atmosphere using a hot plate to form the electron blocking layer.

Next, a polymeric light-emitting organic material (BP 361, manufactured by Sumation Co., Ltd.) was coated on the substrate formed with the electron blocking layer thereon by spin coating to form a film having a thickness of about 70 nm. Then, the film formed on the extraction electrode sections and the sealing area was wiped off.
Next, the substrate was moved to a heating chamber in a vacuum vapor deposition apparatus (Small-ELVESS) manufactured by TOKKI Corporation (hereinafter, the process was carried out in a vacuum or in nitrogen, so that the device is not exposed to air during the process). Then, the substrate was heated at a substrate temperature of about 80 to 120°C for 40 minutes under a degree of vacuum of 1 × 10⁻⁴ Pa or lower.

Subsequently, the substrate was moved to the vapor deposition chamber, and a metal mask for the cathode was positioned so that the cathode would be formed on the light-emitting portion and the extraction sections of the electrodes. Then, the electron injection layer was formed by vapor deposition while rotating the metal mask and the substrate without changing their relative position.

Further, a resistance heating method was used for the vapor deposition of the electron injection layer. Using a molybdenum boat, the electron injection layer material was filled into the boat, and a cover, which had a hole, for preventing the material from bumping and flying about was attached thereto. Next, a current was flowed to the boat to heat it, whereby the material was heated. Consequently, the electron injection layer material was made to evaporate or sublime, so that the electron injection layer material was deposited on the substrate to form the electron injection layer. The degree of vacuum in the chamber prior to starting vapor deposition was 3×10⁻⁵ Pa or lower.

A cesium molybdate (Cs₂MoO₄) powder (purity 99.9%, manufactured by Furuuchi Chemical Corporation) was used as the electron injection layer material. The vapor deposition rate at this stage was about 0.5 nm/sec, and the thickness of the electron injection layer was about 1.5 nm.
Next, using electron beam vapor deposition as the vapor deposition method, an Al film was formed at a vapor deposition rate of about 10 Å/sec to form a 100 nm-thick cathode. The degree of vacuum in the chamber prior to starting vapor deposition was 3 × 10⁻⁵ Pa or lower. Subsequently, a sealing glass coated with a UV-ray curing resin on the periphery of the surface was bonded to the substrate under reduced pressure in an inert gas. Then, the pressure was returned to atmospheric pressure, and UV-rays were irradiated to photo-cure the UV-ray curing resin so that the sealing glass was fixed to the substrate, thereby producing a polymer organic EL device. The light-emitting region of one pixel was 2 mm x 2 mm.

### <Organic EL device evaluation>

Using the organic EL measurement apparatus manufactured by Tokyo System Development Co., Ltd., the current-voltage-luminance and the emission spectrum were measured. When a voltage of about 6.0 V was applied to the organic EL device produced in the present Example, front face luminance was 1,000 cd/m². The current density at this stage was 0.017 A/cm², and the EL emission spectrum exhibited a peak at 460 nm. Further, the emission output efficiency had a maximum value of about 3.4 lm (lumens)/W

### (Example 2)

### <Organic EL device production>

An organic EL device was produced in the same manner as in Example 1, except that a cesium molybdate (Cs₂MoO₄) powder (purity 99.9%, manufactured by Furuuchi Chemical Corporation) was used as the electron injection layer material, and the electron injection layer thickness was about 15 nm.

### <Organic EL device evaluation>

The current-voltage-luminance and the emission spectrum were measured in the same manner as in Example 1. When a voltage of about 4.5 V was applied to the organic EL device produced in the present Example, front face luminance was 1,000 cd/m². The current density at this stage was 0.016 A/cm², and the EL emission spectrum exhibited a peak at 460 nm. Further, the emission output efficiency had a maximum value of about 4.6 lm/W.

### (Example 3)

### <Organic EL device production>

An organic EL device was produced having a device structure of glass substrate/anode formed from an ITO thin film/hole injection layer/light-emitting layer/electron injection layer/cathode/sealing glass. Specifically, the device structure in Example 3 was the same as the device structure in Example 1, minus the electron blocking layer.
An organic EL device was produced in the same manner as in Example 1, except that the step of forming the electron blocking layer was omitted, the heat treatment of the substrate in the heating chamber before forming the electron injection layer was carried out in nitrogen (purity 99.9999% or higher) at a substrate temperature of about 100 to 130°C for 10 minutes, and the electron injection layer was formed having a thickness of about 1.5 nm using a cesium molybdate (Cs₂MoO₄) powder (purity 99.9%, manufactured by Furuuchi Chemical Corporation) as the electron injection layer material.

### <Organic EL device evaluation>

The current-voltage-luminance and the emission spectrum were measured in the same manner as in Example 1. When a voltage of about 4.7 V was applied to the organic EL device produced in the present Example, front face luminance was 1,000 cd/m². The current density at this stage was 0.060 A/cm², and the EL emission spectrum exhibited a peak at 460 nm. Further, the emission output efficiency had a maximum value of about 1.6 lm/W

### (Example 4)

### <Organic EL device production>

An organic EL device was produced in the same manner as in Example 3, except that a potassium molybdate (K₂MoO₄) powder (purity 98%, manufactured by Aldrich) was used as the electron injection layer material, and the electron injection layer thickness was about 1.5 nm.

### <Organic EL device evaluation>

The current-voltage-luminance and the emission spectrum were measured in the same manner as in Example 1. When a voltage of about 8.9 V was applied to the organic EL device produced in the present Example, front face luminance was 1,000 cd/m². The current density at this stage was 0.063 A/cm², and the EL emission spectrum exhibited a peak at 460 nm. Further, the emission output efficiency had a maximum value of about 3.0 lm/W.

### (Example 5)

### <Organic EL device production>

An organic EL device was produced in the same manner as in Example 3, except that an electron injection layer having a thickness of about 1.5 nm was formed using a cesium vanadate (Cs₃VO₄) powder (purity 99.9%, manufactured by Aldrich).

### <Organic EL device evaluation>

The current-voltage-luminance and the emission spectrum were measured in the same manner as in Example 1. When a voltage of about 5.6 V was applied to the organic EL device produced in the present Example, front face luminance was 1,000 cd/m². The current density at this stage was 0.002 A/cm², and the EL emission spectrum exhibited a peak at 460 nm. Further, the emission output efficiency had a maximum value of about 2.4 lm/W.

### (Example 6)

### <Organic EL device production>

An organic EL device was produced in the same manner as in Example 3, except that an electron injection layer having a thickness of about 1.5 nm was formed using a cesium vanadate (CsVO₃) powder (purity 99.9%, manufactured by Aldrich).

### <Organic EL device evaluation>

The current-voltage-luminance and the emission spectrum were measured in the same manner as in Example 1. When a voltage of about 11.0 V was applied to the organic EL device produced in the present Example, front face luminance was 1,000 cd/m². The current density at this stage was 0.4 A/cm², and the EL emission spectrum exhibited a peak at 460 nm. Further, the emission output efficiency had a maximum value of about 0.1 lm/W

### (Example 7)

### <Organic EL device production>

An organic EL device was produced in the same manner as in Example 3, except that an electron injection layer having a thickness of about 1.5 nm was formed using potassium tungstate (K₂WO₄ powder (purity 99.99%, manufactured by Aldrich).

### <Organic EL device evaluation>

The current-voltage-luminance and the emission spectrum were measured in the same manner as in Example 1. When a voltage of about 7.5 V was applied to the organic EL device produced in the present Example, front face luminance was 1,000 cd/m². The current density at this stage was 0.04 A/cm², and the EL emission spectrum exhibited a peak at 460 nm. Further, the emission output efficiency had a maximum value of about 2.5 lm/W.

### <Organic EL device evaluation>

The current-voltage-luminance and the emission spectrum were measured in the same manner as in Example 1. When a voltage of about 4.61 V was applied to the organic EL device produced in the present Example, front face luminance was 1,000 cd/m². The current density at this stage was 0.071 A/cm², and the EL emission spectrum exhibited a peak at 460 nm. Further, the emission output efficiency had a maximum value of about 1.1 lm/W.

### (Comparative Example 1)

### <Organic EL device production>

An organic EL device was produced in the same manner as in Example 3, except that a sodium tungstate dihydrate (Na₂WO₄·2H₂O) powder (purity 99.995%, manufactured by Aldrich) was used as the electron injection layer material, and the electron injection layer thickness was about 1.5 nm.

### <Organic EL device evaluation>

The current-voltage-luminance and the emission spectrum were measured in the same manner as in Example 1. When a voltage of about 15.7 V was applied to the organic EL device produced in the present Example, front face luminance was 100 cd/m². The current density at this stage was 0.096 A/cm², and the EL emission spectrum exhibited a peak at 460 nm. Further, the emission output efficiency had a maximum value of about 0.03 lm/W.

### (Comparative Example 2)

### <Organic EL device production>

An organic EL device was produced in the same manner as in Example 3, except that an electron injection layer having a thickness of about 1.5 nm was formed using a barium molybdate (BaMoO₄) powder (purity 99.9%, manufactured by Aldrich).

### <Organic EL device evaluation>

The current-voltage-luminance and the emission spectrum were measured in the same manner as in Example 1. When a voltage of about 16 V was applied to the organic EL device produced in the present Example, front face luminance was 0.3 cd/m². The current density at this stage was 0.042 A/cm², and the EL emission spectrum exhibited a peak at 460 nm. Further, the emission output efficiency had a maximum value of about 0.0 lm/W.

### INDUSTRIAL APPLICABILITY

According to the present invention, an organic EL device having good luminance and output efficiency can be realized by providing an intermediate layer including a salt of an acid of one or more metals selected from the group consisting of molybdenum, tungsten, vanadium, tantalum, titanium, and Group IIb metals with one or more alkali metals selected from the group consisting of potassium, rubidium, and cesium, between a cathode and a light-emitting layer.

## Claims

1. An organic electroluminescent device formed by laminating at least an anode, a light-emitting layer, an intermediate layer, and a cathode in this order, **characterized in that** the intermediate layer comprises a salt of an acid of one or more metals selected from the group consisting of molybdenum, tungsten, vanadium, tantalum, titanium, and Group IIb metals with one or more alkali metals selected from the group consisting of potassium, rubidium, and cesium.

2. The organic electroluminescent device according to claim 1, wherein the salt is one or more member selected from the group consisting of potassium tungstate, potassium molybdate, cesium molybdate, and cesium vanadate.

3. The organic electroluminescent device according to claim 1 or 2, wherein the content of the salt in the intermediate layer is 5 mass% to 100 mass%.

4. The organic electroluminescent device according to any one of claims 1 to 3, wherein the intermediate layer is arranged in contact with the light-emitting layer.

5. The organic electroluminescent device according to any one of claims 1 to 4, wherein the intermediate layer is arranged in contact with the cathode.

6. The organic electroluminescent device according to any one of claims 1 to 5, wherein light is extracted through the cathode side.

7. The organic electroluminescent device according to any one of claims 1 to 6, wherein the light-emitting layer comprises a polymer compound.

8. A method for manufacturing the organic electroluminescent device according to any one of claims 1 to 7, **characterized in that** the method comprises the steps of:
forming the anode;
forming the light-emitting layer by an applying method;
forming the intermediate layer by vacuum vapor deposition, sputtering, or ion plating using as a starting material a salt of an acid of one or more metals selected from the group consisting of molybdenum, tungsten, vanadium, tantalum, titanium, and Group IIb metals with one or more alkali metals selected from the group consisting of potassium, rubidium, and cesium; and
forming the cathode.
